# EUROPÄISCHE PATENTSCHRIFT

(11) **EP 3 475 472 B1**
(45) Veröffentlichungstag und Bekanntmachung des Hinweises auf die Patenterteilung: **11.08.2021**
(21) Anmeldenummer: 17733997.5
(22) Anmeldetag: 13.06.2017
(51) Int. Cl.: C23C 16/44, C23C 16/455, C30B 25/14, C30B 29/06, C23C 16/458

(54) **VERFAHREN UND VORRICHTUNG ZUR HERSTELLUNG VON BESCHICHTETEN HALBLEITERSCHEIBEN**
METHOD AND DEVICE FOR PRODUCING COATED SEMICONDUCTOR WAFERS
PROCÉDÉ ET DISPOSITIF DE FABRICATION DE TRANCHES SEMI-CONDUCTRICES REVÊTUES

(30) Priorität: 28.06.2016 DE 102016211614
(43) Veröffentlichungstag der Anmeldung: 01.05.2019
(73) Patentinhaber: Siltronic AG, 81677 München (DE)
(72) Erfinder: HABERECHT, Jörg, 09599 Freiberg (DE)
(74) Vertreter: Staudacher, Wolfgang
(86) Internationale Anmeldenummer: PCT/EP2017/064383
(87) Internationale Veröffentlichungsnummer: WO 2018/001720

(56) Entgegenhaltungen:
- KR-A- 20110 104 594
- US-A1- 2002 173 164
- US-A1- 2014 137 801

## Beschreibung

Gegenstand der Erfindung ist ein Verfahren zur Herstellung von beschichteten Halbleiterscheiben, vorzugsweise von Halbleiterscheiben mit epitaktischer Schicht, und eine Vorrichtung zur Durchführung des Verfahrens.

### Stand der Technik / Probleme

Die Herstellung von Halbleiterscheiben beinhaltet häufig das Abscheiden einer Schicht auf einer Substratscheibe in einer Reaktorkammer, in der Substratscheiben einzeln mittels Gasphasenabscheidung (CVD) beschichtet werden. Eine solche Reaktorkammer umfasst Auskleidungen (liners) und einen oberen und einen unteren Deckel, die auch als oberer und unterer Dom bezeichnet werden. Während des Abscheidens einer Schicht liegt die Substratscheibe auf einem Suszeptor und wird durch Strahlung von oberen und unteren Lampenbänken erhitzt, die über und unter dem oberen und unteren Dom angeordnet sind. Ein Prozessgas wird mittels eines Gasinjektors durch Gaseinlassöffnungen in die Reaktorkammer und über die Substratscheibe geleitet, wobei sich das Prozessgas zersetzt und teilweise als Materialschicht auf der Oberfläche der Substratscheibe, die dem Prozessgas ausgesetzt ist, abscheidet. Darüber hinaus kann sich auch Material im Inneren der Reaktorkammer niederschlagen, insbesondere auf einem Vorheizring, der den Suszeptor umgibt. Ein solcher Materialniederschlag, der nicht beabsichtigt ist, muss in bestimmten zeitlichen Abständen durch einen Reinigungsvorgang wieder beseitigt werden. Das geschieht üblicherweise durch eine so genannte Kammerätze, indem an Stelle des Prozessgases ein Ätzgas, das mit dem Materialniederschlag zu gasförmigen Reaktionsprodukten reagiert, durch die Gaseinlassöffnungen in die Reaktorkammer geleitet wird. Die Reaktionsprodukte werden anschließend durch einen Gasauslass aus der Reaktorkammer entfernt.

In US 2015/0 368 796 A1 ist ein Gasinjektor beschrieben, der in einem EpitaxieReaktor verwendet wird. Er versorgt erste und zweite Gaseintrittsöffnungen nacheinander oder gleichzeitig mit einem Prozessgas und mit einem Ätzgas, um einen selektiven epitaktischen Prozess zur Verbesserung der Abscheidung einer epitaktischen Schicht auszuführen.

Die US 6 245 149 offenbart eine Vorrichtung und ein Verfahren zum Beschichten einer Substratscheibe mit einer epitaktischen Schicht, beispielsweise einer epitaktischen Schicht aus Silizium. Das Verfahren beinhaltet auch eine Kammerätze mittels Chlorwasserstoff als Ätzgas.

Die KR 2011 0104594 A offenbart eine Vorrichtung und ein Verfahren zum Beschichten einer Substratscheibe mit einer epitaktischen Siliziumschicht, wobei nach der Abscheidung der epitaktischen Siliziumschicht auf einem Wafer und dessen Entnahme aus der Prozesskammer, diese mit HCl-Ätzgas in-situ gereinigt wird.

Die US 2014 137801 A1 offenbart eine Vorrichtung und ein Verfahren zum Beschichten einer Substratscheibe mit einer epitaktischen Silizium Schicht mittels eines ringförmigen Gaseinlassorgans, in dem erste und zweite Gaseintrittsöffnungen angeordnet sind, wodurch sich kreuzende Strömungsrichtungen erreicht werden.

Eine Kammerätze hat einen Produktivitätsverlust zur Folge, weil deswegen das Beschichten von Substratscheiben unterbrochen werden muss. Wegen der Lage des Vorheizrings in unmittelbarer Nachbarschaft zum Suszeptor ist der unbeabsichtigte Materialniederschlag auf dem Vorheizring am stärksten. Die Dauer einer Kammerätze richtet sich daher im Wesentlichen nach dem Zeitraum, der erforderlich ist, einen Materialniederschlag mit bestimmter Dicke vom Vorheizring zu entfernen.

Aufgabe der Erfindung ist es, diesen Zeitraum möglichst kurz zu gestalten.

Die Aufgabe der Erfindung wird gelöst durch ein Verfahren zur Herstellung von beschichteten Halbleiterscheiben, umfassend das Einleiten eines Prozessgases durch erste Gaseintrittsöffnungen entlang einer ersten Strömungsrichtung in eine Reaktorkammer und über eine Substratscheibe aus Halbleitermaterial zum Abscheiden einer Schicht auf der Substratscheibe, die auf einem Suszeptor liegt, wobei sich auf einem Vorheizring, der um den Suszeptor herum angeordnet ist, Material niederschlägt, das vom Prozessgas stammt; und die Entnahme der beschichteten Substratscheibe aus der Reaktorkammer; gekennzeichnet durch nach der Entnahme der beschichteten Substratscheibe aus der Reaktorkammer: das Entfernen des Materialniederschlags vom Vorheizring durch Einleiten eines Ätzgases durch die ersten Gaseintrittsöffnungen in die Reaktorkammer entlang der ersten Strömungsrichtung und durch zweite Gaseintrittsöffnungen, zwischen denen die ersten Gaseintrittsöffnungen angeordnet sind, über den Vorheizring hinweg entlang weiterer Strömungsrichtungen, die die erste Strömungsrichtung kreuzen.

Die Erfindung sieht vor, Materialniederschlag auf dem Vorheizring im Zuge einer Kammerätze zu entfernen und dabei Ätzgas zusätzlich durch zweite Gaseintrittsöffnungen zu leiten, die zu diesem Zweck vorgesehen sind. Die zweiten Gaseintrittsöffnungen haben im Zusammenhang mit dem Prozessieren einer Substratscheibe keine Bedeutung, weder im Zusammenhang mit dem Beschichten einer Substratscheibe noch im Zusammenhang mit dem Ätzen einer Substratscheibe. Die zweiten Gaseinlassöffnungen sind also nur während des Entfernens des Materialniederschlags vom Vorheizring in Benutzung.

Ätzgas, das während des Entfernens des Materialniederschlags vom Vorheizring aus den ersten Gaseinlassöffnungen strömt, hat eine Strömungsrichtung in Richtung zum Gasauslass. Der so erzeugte Ätzgasstrom hat eine Breite quer zu dieser Strömungsrichtung, die nicht größer ist, als die Länge des Innendurchmessers des Vorheizrings. Das liegt am eigentlichen Zweck der ersten Gaseintrittsöffnungen: der Gasstrom, der durch die ersten Gaseinlassöffnungen in den Reaktionsraum geleitet wird, dient vornehmlich dem Prozessieren einer Substratscheibe, unabhängig davon ob das Prozessieren das Durchleiten von Prozessgas und/oder von Ätzgas beinhaltet. Um die Substratscheibe vollständig zu erfassen, muss sich der erzeugte Gasstrom in einem Korridor bewegen, dessen Breite nicht kleiner ist, als der Durchmesser der Substratscheibe. Der Korridor wird aber auch nicht wesentlich breiter sein, als der Durchmesser der Substratscheibe, um die Wirkung des durchgeleiteten Gases auf die zu prozessierende Substratscheibe zu beschränken.

Der Erfinder der vorliegenden Erfindung hat herausgefunden, dass das Entfernen eines Materialniederschlags vom Vorheizring durch Einleiten eines Ätzgases durch die ersten Gaseintrittsöffnungen nicht besonders effektiv ist.

Die Erfindung schafft hier Abhilfe, indem zweite Gaseinlassöffnungen vorgesehen werden, zwischen denen die ersten Gaseintrittsöffnungen angeordnet sind und durch die Ätzgas zusätzlich und entlang weiterer Strömungsrichtungen, die zum Materialniederschlag auf dem Vorheizring gerichtet sind, geleitet wird. Diese Maßnahme hat zur Folge, dass das Entfernen von Materialniederschlag vom Vorheizring in kürzerer Zeit abgeschlossen werden kann. Die Zeitersparnis ist beträchtlich.

Das Entfernen des Materialniederschlags vom Vorheizring beinhaltet nach der Entnahme der beschichteten Substratscheibe aus der Reaktorkammer das Einleiten eines Ätzgases in die Reaktorkammer durch erste Gaseintrittsöffnungen entlang einer ersten Strömungsrichtung und durch zweite Gaseintrittsöffnungen entlang weiterer Strömungsrichtungen. Die erste Strömungsrichtung ausgehend von den ersten Gaseintrittsöffnungen ist zum Gasauslass der Reaktorkammer gerichtet. Das Ätzgas strömt aus den ersten Gaseintrittsöffnungen in Form eines Ätzgas-Stroms, dessen Breite, betrachtet quer zur ersten Strömungsrichtung, nicht länger ist, als die Länge des Innendurchmessers des Vorheizrings.

Zusätzlich wird Ätzgas durch die zweiten Gaseintrittsöffnungen in die Reaktorkammer entlang der weiteren Strömungsrichtungen geleitet, die die erste Strömungsrichtung kreuzen. Die weiteren Strömungsrichtungen haben deshalb eine Richtungskomponente, die senkrecht zur ersten Strömungsrichtung gerichtet ist.

Die Auswahl der Substratscheibe aus Halbleitermaterial unterliegt grundsätzlich keinen Beschränkungen. Vorzugsweise wird eine Substratscheibe gewählt, die zu beschichtendes einkristallines Halbleitermaterial enthält, beispielsweise eine Halbleiterscheibe aus einkristallinem Silizium, eine SOI-Scheibe (silicon on insulator) oder eine gebondete Halbleiterscheibe. Anstelle von Silizium kann das zu beschichtende Halbleitermaterial ein anderer Halbleiter oder ein Verbindungshalbleiter sein, beispielsweise SiGe oder ein III/V-Verbindungshalbleiter.

Gleichermaßen bestehen grundsätzlich keine Beschränkungen bezüglich der Wahl der abzuscheidenden Schicht. Sie besteht vorzugsweise aus polykristallinem oder einkristallinem Silizium oder aus einem einkristallinen Verbindunghalbleiter, beispielsweise SiGe oder einem III/V-Verbindungshalbleiter. Besonders bevorzugt ist es, eine epitaktische Schicht aus einkristallinem Silizium auf der Substratscheibe aus Halbleitermaterial abzuscheiden.

Bezüglich der Wahl des Ätzgases bestehen ebenfalls keine besonderen Beschränkungen. Im Falle des Abscheidens einer Schicht, die Silizium enthält oder aus Silizium besteht, wird vorzugsweise Ätzgas verwendet, das Chlorwasserstoff enthält oder aus Chlorwasserstoff besteht.

Nach dem Beschichten wird die beschichtete Substratscheibe aus der Reaktorkammer entnommen und begonnen, den Materialniederschlag vom Vorheizring zu entfernen oder eine weitere Substratscheibe in der Reaktorkammer zu beschichten. Vorzugsweise werden mehrere Substratscheiben aus Halbleitermaterial nacheinander beschichtet, bevor mit dem Entfernen des Materialniederschlags vom Vorheizring begonnen wird. Wird die Substratscheibe aus Halbleitermaterial mit einer Schicht beschichtet, die Silizium enthält oder aus Silizium besteht, wird mit dem Entfernen des Materialniederschlags vom Vorheizring vorzugsweise erst begonnen, nachdem der Materialniederschlag auf dem Vorheizring eine Mindestdicke von 50 µm erreicht hat. Mehr als 70 µm an solchem Materialniederschlag anwachsen zu lassen, bevor mit dem Entfernen des Materialniederschlags vom Vorheizring begonnen wird, sollte vermieden werden.

Vor dem Entfernen des Materialniederschlags vom Vorheizring kann auf dem Suszeptor eine Platzhalterscheibe (dummy wafer) abgelegt werden, um die Oberfläche des Suszeptors zu schützen. Diese Maßnahme ist jedoch nicht zwingend notwendig.

Gegenstand der Erfindung ist des Weiteren eine Vorrichtung zum Abscheiden einer Schicht auf einer Substratscheibe, umfassend eine Reaktorkammer mit Auskleidungen und mit einem oberen und einem unteren Deckel;
einen Suszeptor zum Halten einer Substratscheibe;
einen Vorheizring, der den Suszeptor umgibt;
erste Gaseintrittsöffnungen zum Einleiten von Gas in die Reaktorkammer und über den Suszeptor entlang einer ersten Strömungsrichtung; und
zweite Gaseintrittsöffnungen, zwischen denen die ersten Gaseintrittsöffnungen angeordnet sind, zum Einleiten von Ätzgas in die Reaktorkammer und über den Vorheizring hinweg entlang weiterer Strömungsrichtungen, die die erste Strömungsrichtung kreuzen.

Dabei sind die zweiten Gaseintrittsöffnungen achsensymmetrisch bezüglich der ersten Strömungsrichtung als Symmetrieachse und konzentrisch zum Umfang des Vorheizrings entlang eines ersten und eines zweiten Kreisbogens angeordnet. Der erste und der zweite Kreisbogen haben vorzugsweise jeweils eine Länge, die durch einen Mittelpunktswinkel α von nicht weniger als 70 ° und nicht mehr als 100 ° bestimmt ist.

Vorzugsweise ist jeweils eine Anzahl von 15 bis 20 an zweiten Gaseintrittsöffnungen gleichmäßig entlang des ersten und zweiten Kreisbogens verteilt angeordnet. Die zweiten Gaseintrittsöffnungen haben vorzugsweise einen runden Querschnitt mit einem Durchmesser von vorzugsweise 5 mm bis 7 mm.

Die ersten und/oder die zweiten Gaseintrittsöffnungen können in eine oder mehrere Gruppen untergliedert sein.

Ein Gasinjektor leitet Gas zu den ersten und zweiten Gaseintrittsöffnungen, nämlich Prozessgas zu den ersten Gaseintrittsöffnungen beim Beschichten einer Substratscheibe und Ätzgas zu den ersten und zweiten Gaseintrittsöffnungen beim Entfernen eines Materialniederschlags vom Vorheizring. Der Gasinjektor ist vorzugsweise derart konfiguriert, dass mindestens die ersten und zweiten Gaseintrittsöffnungen unabhängig voneinander angesteuert werden können, also jeweils eine Gaszufuhr möglich ist, die sich von der anderen bezüglich Art und/oder Temperatur und/oder Druck und/oder Durchflussgeschwindigkeit des zugeführten Gases unterscheidet. Im Falle einer Untergliederung der ersten und/oder zweiten Gaseintrittsöffnungen in Gruppen kann eine solche Möglichkeit der unabhängigen Ansteuerung der jeweiligen Gruppe ebenfalls vorgesehen sein.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

Die Erfindung wird nachfolgend unter Bezugnahme auf Zeichnungen beschrieben.

### Kurzbeschreibung der Figuren

**Fig. 1** zeigt eine Vorrichtung zum Abscheiden einer Schicht auf einer Substratscheibe, die zur Umsetzung der Erfindung geeignet ist.
**Fig.2** zeigt erfindungsgemäße Merkmale der Vorrichtung in perspektivischer Darstellung.
**Fig.3** zeigt erfindungsgemäße Merkmale der Vorrichtung von oben.

### Liste der verwendeten Bezugszeichen

- **1**: oberer Deckel
- **2**: unterer Deckel
- **3**: Reaktorkammer
- **4**: Substratscheibe
- **5**: Suszeptor
- **6**: Vorheizring
- **7**: obere Auskleidung
- **8**: untere Auskleidung
- **9**: erste Gaseintrittsöffnungen
- **10**: zweite Gaseintrittsöffnungen
- **11**: erster Gasauslass
- **12**: untere Gaseintrittsöffnungen
- **13**: zweiter Gasauslass

### Detaillierte Beschreibung erfindungsgemäßer Ausführungsbeispiele

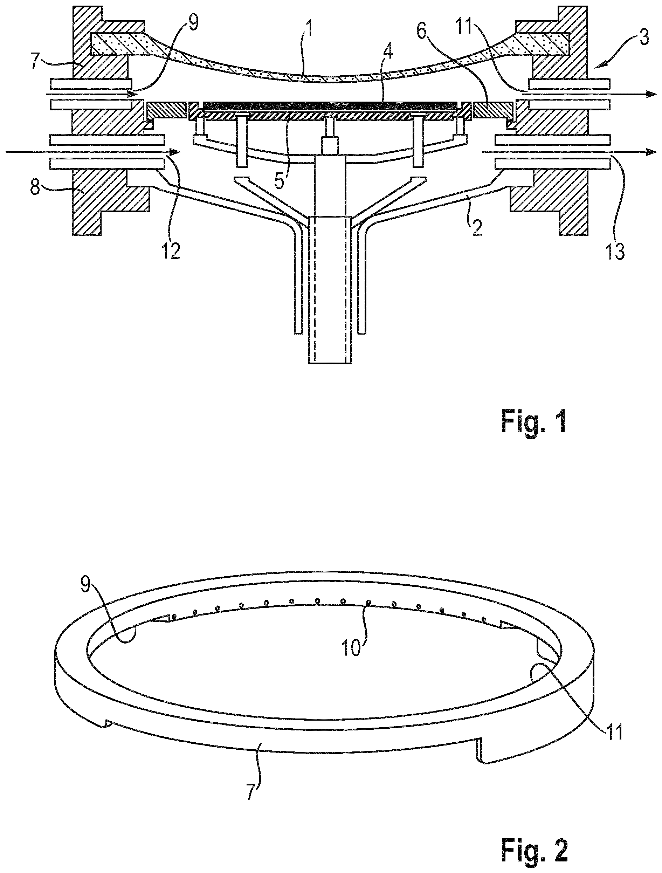

Die in Fig.1 dargestellte Vorrichtung zum Abscheiden einer Schicht auf einer Substratscheibe umfasst eine Reaktorkammer 3 mit einem oberen Deckel 1 und einem unteren Deckel 2 und obere und untere Auskleidungen 7 und 8, die einen Reaktionsraum umschließen. Außerhalb der Reaktorkammer 3 vorhandene obere und untere Lampenbänke sind nicht dargestellt.

Eine Substratscheibe 4 ist auf einem Suszeptor 5 abgelegt, der von unten durch Arme eines Trägers drehbar gehalten wird. Die Substratscheibe 4 kann mittels Hebestiften, die durch den Suszeptor 5 durchgeführt sind, auf dem Suszeptor 5 abgelegt und nach dem Beschichten vom Suszeptor 5 weggehoben werden.

Beim Beschichten der Substratscheibe 4 wird Prozessgas durch erste Gaseintrittsöffnungen 9, die in der oberen Auskleidung 7 vorgesehen sind, in die Reaktorkammer 3 entlang einer ersten Strömungsrichtung über die Substratscheibe zu einem ersten Gasauslass 11 gleitet. Darüber hinaus können optional untere Gaseintrittsöffnungen 12 und ein zweiter Gasauslass 13 vorgesehen sein, um ein Spülgas unter dem Suszeptor 5 vorbei zum zweiten Gasauslass 13 zu leiten.

Die obere Auskleidung 7 ist in Fig.2 perspektivisch dargestellt. Neben den ersten Gaseintrittsöffnungen 9 sind zweite Gaseintrittsöffnungen 10 vorhanden. Ätzgas, das zum Entfernen des Materialniederschlags vom Vorheizring durch die ersten und zweiten Gaseintrittsöffnungen 9 und 10 in die Reaktorkammer geleitet wird, verlässt die Reaktorkammer wieder durch den ersten Gasauslass 11.

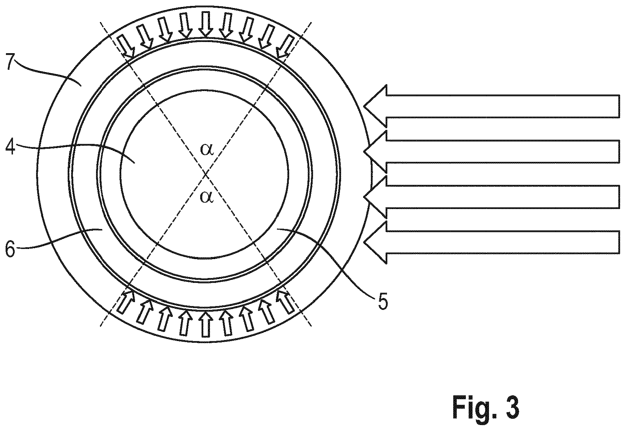

Fig.3 zeigt von oben eine Anordnung umfassend die obere Auskleidung 7 gemäß Fig.2, den Vorheizring 6, den Suszeptor 5 und die Substratscheibe 4. Beim Abscheiden einer Schicht auf der Substratscheibe 4 strömt Prozessgas entlang der ersten Strömungsrichtung, die durch lange Pfeile symbolisiert ist, über die Substratscheibe 4 hinweg zum ersten Gasauslass. Die Breite des Prozessgas-Stroms, der die ersten Gaseintrittsöffnungen 9 verlässt, ist vorzugsweise größer als der Durchmesser der Substratscheibe und nicht größer als der Innendurchmesser des Vorheizrings. Nicht dargestellt ist ein vorhandener Gasinjektor zum voneinander unabhängigen Zuführen von Gas zu den ersten und zweiten Gaseintrittsöffnungen 9 und 10. Während des Abscheidens einer Schicht auf der Substratscheibe 4 wird kein Gas durch die zweiten Gaseintrittsöffnungen geleitet.

Die kurzen Pfeile symbolisieren weitere Strömungsrichtungen, entlang derer ein Ätzgas strömt, das zum Entfernen eines Materialniederschlags vom Vorheizring 6 nach der Entnahme der beschichteten Substratscheibe 4 aus der Reaktorkammer durch die zweiten Gaseintrittsöffnungen 10 über den Vorheizring 6 hinweg entlang der weiteren Strömungsrichtungen geleitet wird. Gleichzeitig wird Ätzgas durch die ersten Gaseintrittsöffnungen entlang der ersten Strömungsrichtung in die Reaktorkammer eingeleitet. Die Breite des durch die ersten Gaseintrittsöffnungen eingeleiteten Ätzgas-Stroms entspricht vorzugsweise der Breite des Prozessgas-Stroms. Die weiteren Strömungsrichtungen kreuzen die erste Strömungsrichtung und haben daher jeweils eine Richtungskomponente senkrecht zur ersten Strömungsrichtung.

### Beispiel:

Die Erfindung wurde praktisch getestet. Auf Substratscheiben aus Silizium wurde eine epitaktische Schicht aus Silizium abgeschieden. Durch den Einsatz des erfindungsgemäßen Verfahrens konnte der Zeitaufwand für das Entfernen des Materialniederschlags vom Vorheizring um bis zu 40 % gegenüber einem Verfahren verkürzt werden, bei dem während des Entfernens des Materialniederschlags vom Vorheizring nur die ersten Gaseintrittsöffnungen in Benutzung waren.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Verfahren zur Herstellung von beschichteten Halbleiterscheiben, umfassend das Einleiten eines Prozessgases durch erste Gaseintrittsöffnungen (9) entlang einer ersten Strömungsrichtung in eine Reaktorkammer (3) und über eine Substratscheibe (4) aus Halbleitermaterial zum Abscheiden einer Schicht auf der Substratscheibe (4), die auf einem Suszeptor (5) liegt, wobei sich auf einem Vorheizring (6), der um den Suszeptor (5) herum angeordnet ist, Material niederschlägt, das vom Prozessgas stammt; und die Entnahme der beschichteten Substratscheibe (4) aus der Reaktorkammer (3); nach der Entnahme der beschichteten Substratscheibe (4) aus der Reaktorkammer (3): das Entfernen des Materialniederschlags vom Vorheizring (6) durch Einleiten eines Ätzgases durch die ersten Gaseintrittsöffnungen (9) in die Reaktorkammer (3) entlang der ersten Strömungsrichtung;
**dadurch gekennzeichnet, dass**
das Einleiten des Ätzgases zusätzlich durch zweite Gaseintrittsöffnungen (10), zwischen denen die ersten Gaseintrittsöffnungen (9) angeordnet sind, über den Vorheizring (6) hinweg entlang weiterer Strömungsrichtungen, die die erste Strömungsrichtung kreuzen, erfolgt.

2. Verfahren nach Anspruch 1, **gekennzeichnet durch** vor dem Einleiten des Ätzgases in die Reaktorkammer: das Wiederholen des Abscheidens einer Schicht auf einer Substratscheibe aus Halbleitermaterial und der Entnahme der beschichteten Substratscheibe aus der Reaktorkammer solange, bis der Materialniederschlag auf dem Vorheizring eine Mindestdicke erreicht hat.

3. Verfahren nach Anspruch 2, **dadurch gekennzeichnet, dass** das Ätzgas Chlorwasserstoff enthält und der Materialniederschlag auf dem Vorheizring die Mindestdicke von 50 µm hat und Silizium enthält.

4. Verfahren nach einem der Ansprüche 1 bis 3, **gekennzeichnet durch** das Abscheiden einer epitaktischen Schicht aus Silizium auf der Substratscheibe.

5. Vorrichtung zum Abscheiden einer Schicht auf einer Substratscheibe (4), umfassend eine Reaktorkammer (3) mit Auskleidungen (7,8) und mit einem oberen Deckel (1) und einem unteren Deckel (2); einen Suszeptor (5) zum Halten einer Substratscheibe (4); einen Vorheizring (6), der den Suszeptor (5) umgibt; erste Gaseintrittsöffnungen (9) zum Einleiten von Gas in die Reaktorkammer (3) und über den Suszeptor (5) entlang einer ersten Strömungsrichtung; **gekennzeichnet durch** zweite Gaseintrittsöffnungen (10), zwischen denen die ersten Gaseintrittsöffnungen (9) angeordnet sind, zum Einleiten von Ätzgas in die Reaktorkammer (3) und über den Vorheizring (6) hinweg entlang weiterer Strömungsrichtungen, die die erste Strömungsrichtung kreuzen, wobei die zweiten Gaseintrittsöffnungen (10) achsensymmetrisch bezüglich der ersten Strömungsrichtung als Symmetrieachse und konzentrisch zum Umfang des Vorheizrings (6) entlang eines ersten und eines zweiten Kreisbogens angeordnet sind, wobei der erste und der zweite Kreisbogen jeweils eine Länge haben, die durch einen Mittelpunktswinkel α von nicht weniger als 70 ° und nicht mehr als 100 ° bestimmt ist.

6. Vorrichtung nach Anspruch 5, **gekennzeichnet durch** eine Anzahl von 15 bis 20 an zweiten Gaseintrittsöffnungen, die jeweils entlang des ersten und zweiten Kreisbogens gleichmäßig verteilt angeordnet sind.

7. Vorrichtung nach Anspruch 5 oder Anspruch 6, **dadurch gekennzeichnet, dass** die Reaktorkammer als Epitaxiereaktor konfiguriert ist.

## Claims

1. A method of manufacturing coated semiconductor wafers, comprising introducing a process gas through first gas inlet ports along a first flow direction into a reactor chamber and over a substrate wafer of semiconductor material to deposit a layer on the substrate wafer overlying a susceptor, wherein material originating from the process gas is deposited on a preheating ring disposed around the susceptor; and removing the coated substrate wafer from the reactor chamber; **characterized by** after removing the coated substrate wafer from the reactor chamber: removing the material deposit from the preheating ring by introducing an etchant gas through the first gas inlet openings into the reactor chamber along the first flow direction and through second gas inlet openings, between which the first gas inlet openings are located, across the preheating ring along further flow directions crossing the first flow direction.

2. Method according to claim 1, **characterized by**
before introducing the etch gas into the reactor chamber: repeating the deposition of a layer on a substrate wafer of semiconductor material and the removal of the coated substrate wafer from the reactor chamber until the material deposit on the preheating ring has reached a minimum thickness.

3. Method according to claim 2, **characterized in that** the etching gas contains hydrogen chloride and the material deposit on the preheating ring has the minimum thickness of 50 µm and contains silicon.

4. Method according to any one of claims 1 to 3, **characterized by** depositing an epitaxial layer of silicon on the substrate wafer.

5. Apparatus for depositing a layer on a substrate wafer, comprising
a reactor chamber with liners and with an upper and a lower lid;
a susceptor for holding a substrate disk;
a preheating ring surrounding the susceptor;
first gas inlet ports for introducing gas into the reactor chamber and across the susceptor along a first flow direction; and
second gas inlet openings, between which the first gas inlet openings are arranged, for introducing etching gas into the reactor chamber and across the preheating ring along further flow directions crossing the first flow direction, wherein the second gas inlet openings are arranged axially symmetrically with respect to the first flow direction as an axis of symmetry and concentrically with respect to the circumference of the preheating ring along a first and a second circular arc, the first and the second circular arc each having a length determined by a central angle α of not less than 70 ° and not more than 100 °.

6. Apparatus according to claim 5, **characterized by** a number of 15 to 20 of second gas inlet openings, each of which is uniformly distributed along the first and second circular arcs.

7. Apparatus according to claim 5 or claim 6, **characterized in that** the reactor chamber is configured as an epitaxy reactor.

## Revendications

1. Un procédé de fabrication de plaquettes de semi-conducteurs revêtues,
comprenant
l'introduction d'un gaz de traitement à travers des premiers orifices d'entrée de gaz le long d'une première direction d'écoulement dans une chambre de réacteur et sur une tranche de substrat de matériau semi-conducteur pour déposer une couche sur la tranche de substrat recouvrant un suscepteur, dans lequel le matériau dérivé du gaz de traitement est déposé sur un anneau de préchauffage disposé autour du suscepteur ; et
l'enlèvement de la plaquette de substrat revêtue de la chambre de réacteur ; **caractérisé par** après l'enlèvement de la plaquette de substrat revêtue de la chambre de réacteur : l'enlèvement du dépôt de matériau de l'anneau de préchauffage en introduisant un gaz d'attaque par les premiers orifices d'entrée de gaz dans la chambre de réacteur le long de la première direction d'écoulement et par les seconds orifices d'entrée de gaz, entre lesquels sont situés les premiers orifices d'entrée de gaz, à travers l'anneau de préchauffage le long d'autres directions d'écoulement croisant la première direction d'écoulement.

2. Procédé selon la revendication 1, **caractérisé par**
avant d'introduire le gaz d'attaque dans la chambre du réacteur : répéter le dépôt d'une couche sur une plaquette de substrat de matériau semi-conducteur et le retrait de la plaquette de substrat revêtue de la chambre du réacteur jusqu'à ce que le dépôt de matériau sur l'anneau de préchauffage ait atteint une épaisseur minimale.

3. Procédé selon la revendication 2, **caractérisé en ce que** le gaz de gravure contient du chlorure d'hydrogène et le dépôt de matériau sur l'anneau de préchauffage a une épaisseur minimale de 50 µm et contient du silicium.

4. Procédé selon l'une quelconque des revendications 1 à 3, **caractérisé par** le dépôt d'une couche épitaxiale de silicium sur la tranche de substrat.

5. Appareil pour déposer une couche sur une tranche de substrat, comprenant
une chambre de réacteur avec des revêtements et avec un couvercle supérieur et un couvercle inférieur;
un suscepteur pour maintenir un disque de substrat ;
un anneau de préchauffage entourant le suscepteur ;
des premiers orifices d'entrée de gaz pour introduire du gaz dans la chambre du réacteur et sur le suscepteur le long d'une première direction d'écoulement ; et
des deuxièmes ouvertures d'entrée de gaz, entre lesquelles sont disposées les premières ouvertures d'entrée de gaz, pour introduire du gaz de décapage dans la chambre du réacteur et à travers l'anneau de préchauffage le long d'autres directions d'écoulement qui croisent la première direction d'écoulement dans lequel les secondes ouvertures d'entrée de gaz sont disposées axialement de manière symétrique par rapport à la première direction d'écoulement en tant qu'axe de symétrie et concentriquement par rapport à la circonférence de l'anneau de préchauffage le long d'un premier et d'un second arc de cercle, dans lequel le premier et le second arc de cercle ont chacun une longueur qui est déterminée par un angle central α non inférieur à 70 ° et non supérieur à 100 °.

6. Appareil selon la revendication 5, **caractérisé par** un nombre de 15 à 20 de secondes ouvertures d'entrée de gaz, dont chacune est uniformément répartie le long des premier et second arcs de cercle.

7. Appareil de la revendication 5 ou de la revendication 6, **caractérisé en ce que** la chambre du réacteur est configurée comme un réacteur épitaxial.
